(19) **Europäisches Patentamt**

**European Patent Office**

**Office européen des brevets**

(11) **EP 1 111 799 B1**

(12) **EUROPEAN PATENT SPECIFICATION**

(45) Date of publication and mention
of the grant of the patent:
**03.09.2003 Bulletin 2003/36**

(51) Int Cl.$^7$: **H03M 13/27**, H03M 13/29,
G11B 20/18

(21) Application number: **00127012.3**

(22) Date of filing: **09.12.2000**

(54) **Error correction with a cross-interleaved Reed-Solomon code, particularly for CD-ROM**

Fehlerkorrektur mit einem cross interleave Reed-Solomon Code, insbesondere für CD-ROM

Correction d'erreurs avec un code de type cross interleave Reed-Solomon, en particulier pour CD-ROM

(84) Designated Contracting States:
**DE FR GB IT**

(30) Priority: **21.12.1999 EP 99250443**

(43) Date of publication of application:
**27.06.2001 Bulletin 2001/26**

(73) Proprietor: **DEUTSCHE THOMSON-BRANDT
GMBH
78048 Villingen-Schwenningen (DE)**

(72) Inventors:
• **Kravtchenko, Alexander
78056 Villingen-Schwenningen (DE)**

• **Rominger, Friedrich
78086 Brigachtal (DE)**
• **Vogel, Jürgen
78086 Brigachtal (DE)**

(74) Representative:
**Schäferjohann, Volker Willi, Dipl.-Phys. et al
Deutsche Thomson-Brandt GmbH
European Patent Operations
Karl-Wiechert-Allee 74
30625 Hannover (DE)**

(56) References cited:
**EP-A- 0 652 561      US-A- 5 506 823
US-A- 5 870 366**

**Description**

The invention relates to a method and an apparatus for correcting errors in a stream of data by using a method of decoding a cross-interleaved Reed-Solomon code (CIRC).

Background

There has been a demand for increased quality of audio recording and read back systems as well as of other types of communication.

One problem with recording media are the defects in the media resulting in areas with unproperly recorded digital data or in data that cannot be read back reliably. As a result errors occur in the read back data as well as in transmissions of digital data. During recording, read back and transmission of digital data, errors occur in the digital data with some finite probability. The data is typically composed of binary units, a group of binary units (such as 8) makes up a data byte, and groups of bytes (such as 2) make up a data word. Additionally the data is arranged into blocks of data (such as 32 or 28 byte blocks).

There are two different types of errors. The first type is a single bit error which is the substitution of one of two possible values of a binary bit for its opposite value. Such errors usually occur randomly in a digital signal. A second type of error consists of a continuous sequence of erroneous bits. Such errors are referred to as burst errors. The length of these bursts and their frequency of occurrence are also random.

One error correction code that is typically used in compact audio discs is a so-called CIRC correction code. CIRC is an acronym for cross-interleaved Reed-Solomon code. The CIRC utilises a two-step process. In passing through a first encoder, 24 consecutive data bytes representing a data polynomial are divided by a generator polynomial. In this process, four parity bytes are added. The result is a block of 24 data bytes and 4 parity bytes (C2 code). This consecutive sequence of bytes is interleaved or dispersed among other encoded data bytes.

The interleaved data is passed through a second encoder. The second encoder is identical to the first except that the bytes are presented in a different sequence due to interleaving, parity bytes together with data bytes are being encoded, blocks of 28 bytes (28 data bytes plus 4 parity bytes) are being encoded instead of 24 byte blocks, and 4 additional parity bytes are added. The result of the second encoding process is a 32 byte block (C1 code) composed of 24 data bytes and 8 parity bytes.

In the case of the CIRC correction code, the encoding process of the (28, 24) Reed-Solomon code is performed for twenty-four data symbols (bytes), with each symbol consisting of 8 bits. In typical audio applications each audio sample comprises 16 bits and is formed of two symbols of 8 bits each. Thus, each 8-bit symbol is either the upper or lower side of an audio sample of one of the two channels of stereophonic audio data.

The encoded data is recorded optically and subsequently read back. After the encoded data is read back, there will likely be single bit or burst errors due to recording, read back or transmission problems.

Conventional error correction methods are known for use in decoding CIRC. Examples of such methods are disclosed in US-A-4 546 474, US-A-4 476 562 and US-A-4 497 058. According to the conventional methods for decoding CIRC errors, the processing is run on the basis of a so-called erasure correction method. In the erasure correction method the location of error symbols is indicated by means of pointer information. Error correction is performed on this error symbol. In the case of above-mentioned C1 and C2 codes, detection and correction up to double errors can be performed. However, if the error location is already know, then error correction up to 4 erasures can be performed. Therefore, in order to raise the error-correction capability, the implementation of the erasure correction method for error correction has been preferred. In addition, the erasure correction method has been found to be particularly effective in correcting burst errors.

According to the conventional method used for decoding CIRC errors, correction of up to two errors is performed in the C1 decoder. If triple errors or more occur, which of course are not corrected, C1 pointer information is sent to the C2 decoder in the next stage, so that error correction is performed in the C2 decoder utilising C1 pointer information.

Multiple use of the CIRC correction codes in decoding leads to an increase in correction capability of error correction systems. However, conventional decoding methods (CIRC decoders) are incapable of multiple processing of blocks of CIRC codes. In order to solve this problem, one can either provide conventional CIRC decoders with additional means or devices which allow multiple processing or make conventional CIRC decoders useful for multiple processing.

One method (conventional CIRC decoder) for multiple processing of CIRC codes has been disclosed in US-A-4 852 099. The known method uses the erasure correction method to increase the correction capability of error correction systems. It is proposed to perform C1 decoding and C2 decoding twice in a specific order. That order, for example, might be, C1 decoding, followed by C2 decoding, followed by C1 decoding, and followed by C2 decoding.

According to this example, C1 code words are supplied to a C1 decoder in which actual decoding of the (32, 28) Reed-Solomon code is performed. Error correction of up to two errors is performed. If three or more errors are detected by the C1 decoder, a C1 pointer is set for all symbols in C1 code words. Then data and error pointers corrected by means of C1 decoder are further processed in a deinterleave processing stage. An output of the deinterleaver is supplied to the C2 decoder. Erasure correction of up to four erasures is executed in the C2 decoder utilising C1 pointer information. Upon completion of erasure correction in the C2 decoder the C1 pointer is cleared and no pointer information is transferred to the second C2 decoding cycle.

In a second cycle data from the C2 decoder is supplied to the interleaver that returns the data to the same arrangement as it was when it was reproduced. Thereafter, the processing in the second decoding cycle corresponds to the processing in the first decoding cycle. By using this decoding method, multiple processing of CIRC codes can be performed, but additional hardware (interleaver block) is needed.

Another method used in decoding CIRC utilising multiple processing of CIRC is disclosed in US-A-4 637 021. Error detection and error correction is achieved by processing blocks of digital data bytes with a C1 decoder and a C2 decoder. In order to maximise the rate at which data is processed, decoders C1 and C2 actually operate concurrently on data stored in a system memory with the C1 decoder operating on the data ahead of the C2 decoder. According to the disclosed decoding method of the CIRC correction code, error processing up to double-error correction is executed in C1 decoding in first stage, and double-error correction is executed in C2 decoding at next stage by referring to C1 pointer information that is derived from the C1 decoder. In this case, C1 pointer information is not used to increase the error correction capability of error correction systems. C1 pointer information is used to check the quality of the decoding process.

In the method according to the US-A-4 637 021, data bytes are read by means of C1 and C2 decoders from the system memory according to the following sequence. A first C1 decoder processes a C1 block of data bytes (32 bytes). A first C2 decoder then processes a C2 block of data bytes (28 bytes) that has already been processed by the C1 decoder; this concludes a first pass. A second C1 decoder processes data bytes that have already been processed by the first pass, and a second C2 decoder processes data bytes that have already been processed by the first pass and the second C1 decoder; this concludes a second pass. A decoder cycle comprises the execution of both, the first pass and the second pass. At the end of each decoder cycle, an address counter is incremented, and the decoder cycle is repeated. New data is immediately written into memory locations when the data (C1 block) in the input buffer is ready. Thus, during operation the reading of the four decoders continually advances through the memory until available data has been processed.

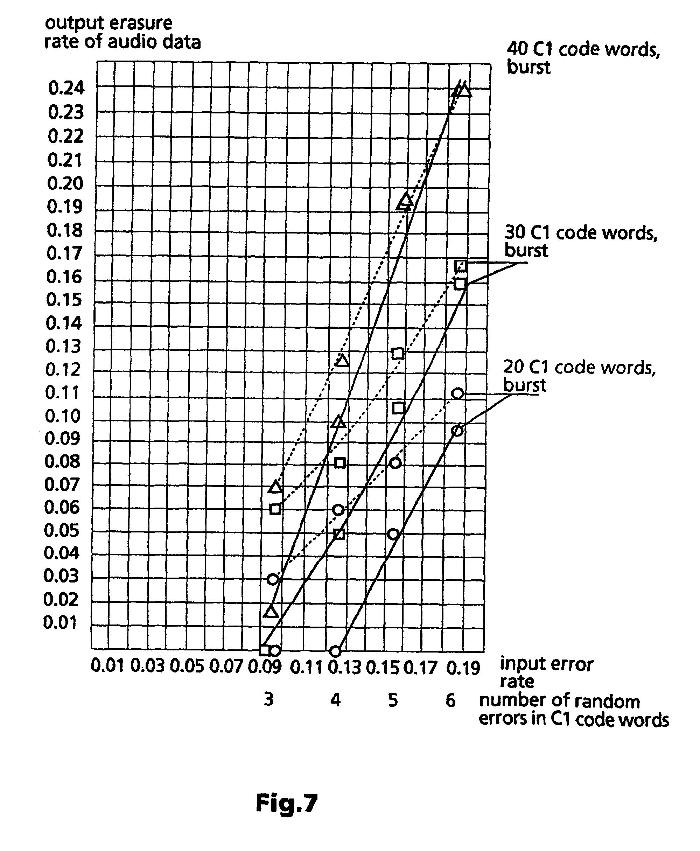

The method according to US-A-4 637 021 for use in decoding CIRC is implemented by utilising a deinterleaver implementation and a special method of controlling data. A deinterleaver block is provided in a system memory (256x32 bytes) and consists of two blocks, a C1 memory block (128x32 bytes) and a C2 memory block (128x32 bytes). The C1 memory block includes addresses in rows 112 to 239. C2 memory block includes addresses in rows 240 to 255 and then in rows 0 to 111. The system memory is circular. The lowest numbered system memory address "follows" the highest numbered one. This is depicted in Fig. 7.

According to the known method, the first C1 decoder processes the C1 memory block of 32 data bytes. The C1 decoder is initially positioned to read the C1 memory block at address 112. In each succeeding decoder cycle (execution of two passes by both, C1 and C2 decoders), the C1 decoder is positioned to read the C1 memory block at the next successively higher address. Thus, for the second cycle the C1 memory block is positioned at position 113.

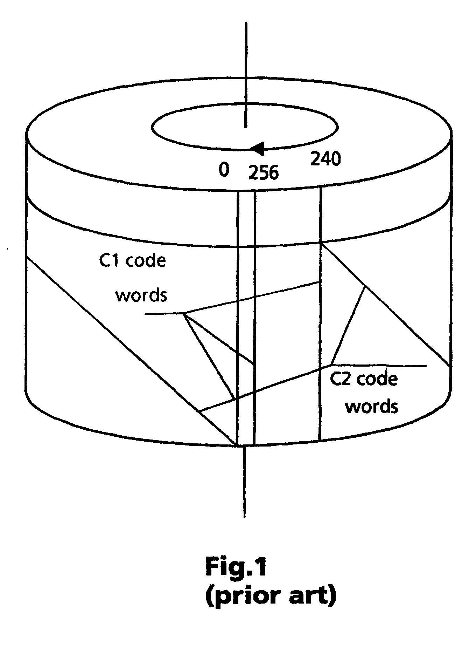

The first C2 decoder processes a C2 memory block of 28 data bytes. The C2 decoder is initially positioned to read the C2 memory block at address 0 of the system memory. Those bytes building the C2 memory block are arranged along a diagonal of the system memory (see Fig. 1). Those bytes building the C2 memory block are changed into successive decoding cycles.

At the beginning of the second C1 pass, the C1 decoder is positioned to read the C1 memory block at address 240 of the system memory. At the beginning of the second C2 pass, the C2 decoder is initially positioned to read the C2 memory block at address 113 of the system memory. The execution of four decoding passes (one decoder cycle) continually advances through the system memory. If unprocessed data is still in the system memory, the decoding cycles are continued. If all data in the system memory is corrected, the operation of the error correction system is completed.

From US-A-5 870 366 a recording / reproducing apparatus is known in which the interleaving scheme of the standard CIRC encoding method is modified so that it spreads the data of a frame over 98 frames, which is the size of one sector, instead of 108 frames as usually, thus reducing the to two the number of sectors to be accessed in a reading operation by adapting the interleaving depth to the sector size.

Further documents describing C1 and C2 coding / decoding processes in disc recording / reproducing apparatuses are EP-A-0 652 561 and US-A-5 506 823.

Invention

The method for decoding CIRC correction codes as described above has the following disadvantages:

a) Data in the system memory is processed during 256 cycles (four decoding passes in each decoder cycle). If all data in the system memory is corrected, the operation of error correction system is completed. When sufficient data is available in the input buffer, an interruption in the system memory processing occurs in order to allow the C1 memory block to be written into the system memory. Interruptions can occur several times during the system memory processing (256 cycles). Therefore, any data in the system memory can't be processed twice (first C1, C2 passes and second C1, C2 passes).

b) Two decoders (C1 decoder and C2 decoder) need to be used concurrently on data stored in the system memory. Therefore, additional hardware is necessary.

c) The erasure correction method for Reed-Solomon codes cannot be used in conjunction with the method described above.

It is an object of the invention to disclose a method and an apparatus for use in decoding cross-interleaved Reed-Solomon code (CIRC) that efficiently corrects errors in a stream of data while hardware expenses are reduced.

It is another object of the invention to provide a method and an apparatus for use in decoding cross-interleaved Reed-Solomon code (CIRC) that corrects errors in a stream of data by utilising the so-called erasure correction method.

According to one aspect of the invention an error-correction method for use in a process of decoding cross-interleaved Reed-Solomon code CIRC is provided that corrects errors in a block of 109 C1 code words each consisting of 32 data bytes, and a block of 109 C2 code words each consisting of 28 data bytes, said block of C1 code words being positioned in a memory comprising a memory block with memory locations $N_{ij}$ for the data bytes with i=0, ..., 217; j=0, ..., 31 at the positions i=109, ... ,217 and j=0, ..., 31; said block of C2 code words being located along diagonals of said memory, said diagonals starting at the positions i=0, ..., 108 and j=0 and ending at the positions i=108, ..., 216 and j=27; a previous block of C1 code words being positioned in the memory at the positions i=0, ... ,108 and j=0, ..., 31; the method comprising the following steps:

a1) reading and decoding (450) said C1-code words in the current block from said locations $N_{ij}$ utilising decoder means (5) starting by i=109 and j=0;
a2) correcting said C1-code words at least partially;
b1) reading and decoding (460) said C2-code words from said locations $N_{ij}$ utilising said decoder means (5) along said diagonals of said memory starting by position i=0 and j=0; and
b2) correcting said C2-code words at least partially;
c) repeating steps a1, a2 and b1, b2.

This method provides reading and decoding of C1 and C2 code words in a novel manner. This means that the new method implies specific regulations for defining which data words are to be used for C1 and C2 decoding and for the processing order. The system memory for a deinterleaver implementation can be of a smaller size as compared to conventional system memories. In addition, only a single CIRC decoder needs to be used for performing the method according to the invention.

The correction of a large burst error in C1 code words can be executed very efficiently for a low input error rate.

According to another aspect of the invention a novel apparatus for running the above-provided error correction method is disclosed in claim 11.

Advantageous features of the invention according to the independent claims are disclosed in associated dependent claims.

Drawings

Exemplary embodiments of the invention are illustrated in the drawings and are explained in more detail in the follow ing description.

Fig. 1    shows an example of a system memory used in conjunction with a conventional error correction method;
Fig. 2    shows a block diagram of a CIRC decoder suitable for performing the method according to the invention;
Fig. 3    shows a schematic representation of a memory block with memory blocks B1 and B2 in accordance with the invention;
Fig. 4    shows a flow chart of the method according to the invention;
Fig. 5    shows the memory block of Fig. 3 with memory sectors;

Fig. 6    shows the memory block of Fig. 5 with memory block B1 moved into memory block B2; and

Fig. 7    shows a diagram that compares results of a conventional error correction method and the error correction method according to the invention, respectively.

Exemplary embodiments

*1. System Components*

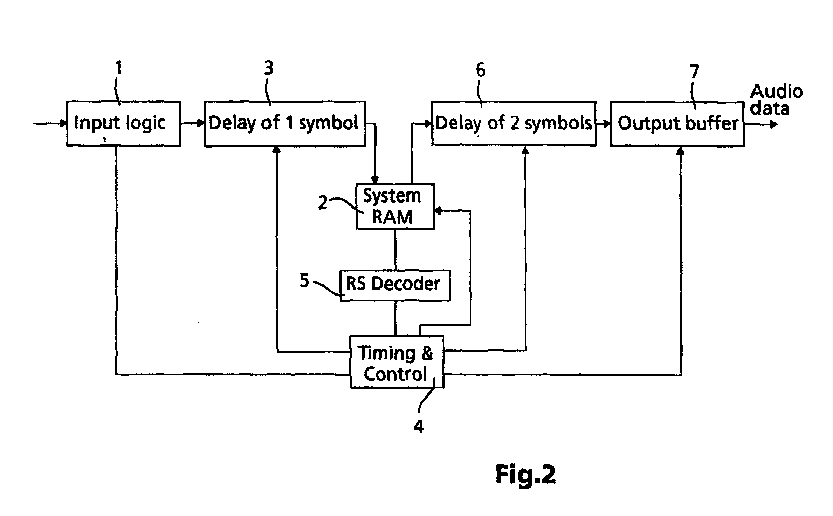

Fig. 2 is a block diagram of a CIRC decoder according to the invention.

A data stream from an acquisition part is stored in an input logic 1. Input logic 1 is able to store 109 C1 code words (32 bytes) in an input buffer. When sufficient data is available in the input buffer a data block (109x32) is written into a system memory 2, which preferably is a RAM. In system memory 2 two memory blocks B1, B2 are formed for storing data bytes.

A "delay of 1 symbol" element 3 is used for data delay as known from conventional CIRC decoders.

Means for addressing and determining memory locations in system memory 2 at which read, write, or error correction operations are to be run, are comprised in a timing and control element 4.

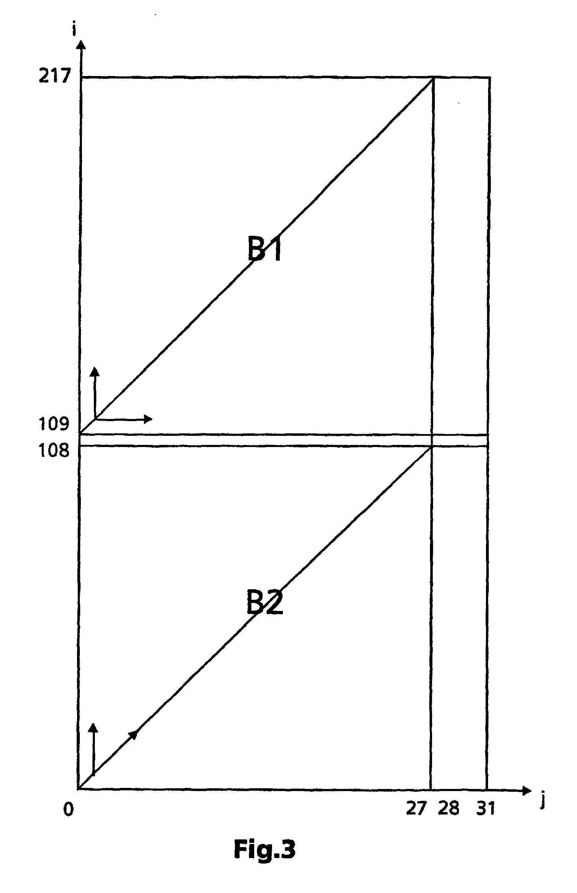

For a better understanding, data bytes in system memory 2 are considered to be elements of a two dimensional Cartesian coordinate system as depicted in Fig. 3. This assumption is independent of a real hardware implementation of system memory 2.

Each vertical or i-axis position contains 32 bytes of C1 code words (see Fig.3). Each horizontal or j-axis represents an 8 bit byte at each j-axis position. Bytes are numbered sequentially within each j-position moving from left to right. That is in accordance with systematic of Reed-Solomon (RS) code. Parity bytes are in positions 28 to 31.

According to Fig. 2, a conventional RS decoder 5 is connected to system memory 2 and timing and control element 4. In the conventional RS decoder 5 so-called erasure correction method of RS code is implemented. RS decoder 5 is able to correct 4 erasures or 2 errors or any combinations of errors and erasures in accordance with: $2*t+E<d$, where t is the number of errors in a code word, E is the number of erasures, and d is the Hamming distance of RS code. For a compact audio disc applications d is 4.

Addressing and determining of locations in the system memory 2 and the controlling of transferred data bytes during read, write and correction operations are performed utilising a timing and control element 5.

A delay of 2 symbols is performed in a "delay of 2 symbol" element 6. A C2 code word is corrected after a second decoder cycle of CIRC decoder is written into an output buffer 7.

*2. Detailed operations of error-correction method according to the invention*

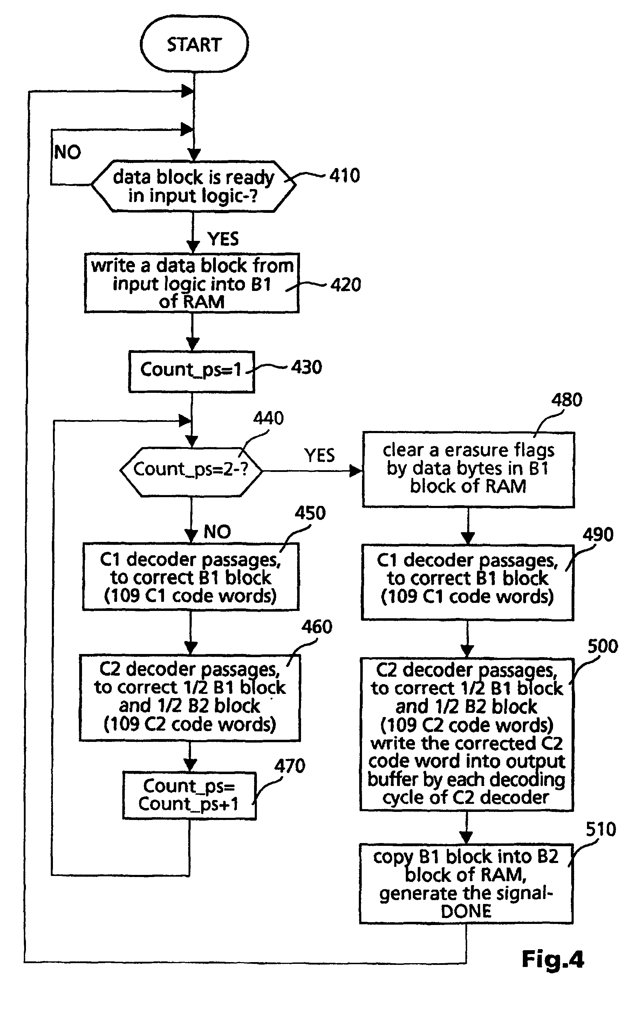

Referring to Fig. 4, operations of the new decoding method for multiple processing of a CIRC correction code are described in detail. When sufficient data is available in input logic 1 a data block (109x32 bytes) is written to i-positions 109, 110, ..., 217 of the system memory 2 (see Fig. 3), steps 410 and 420.

A counter pass of a B1 memory block initially is initialised with 1 (430 in Fig. 4). Then a condition-Count_ps=2-? is analysed, step 440. If the result is NO then a step 450 is performed. In step 450 a RS decoder 5 which, at this time is in C1 level, is positioned for reading C1 code word (32 bytes, along j-positions for j=0, 1, ..., 31) at i-position 109. In each succeeding C1 decoder cycle the RS decoder 5 is positioned forward and reads C1 code word at the successively next higher valued i-position. Thus, during the second C1 decoder cycle the RS decoder 5 is positioned at i-position 110. In the same manner the addressing is continued until i-position 217 is read for all j-positions (j=0, 1, ..., 31).

In each C1 decoder cycle the RS decoder 5 tries to correct up to two errors. If three or more errors occur, which of course are not corrected, erasure flags are assigned to all uncorrected data bytes of C1 code word. Erasure flags are stored in an additional memory block (not shown) of system memory 2.

In general, the RS decoder 5 (at C1 level) performs continuously 109 decoding and correcting cycles (450 in Fig. 4). Then the B1 memory block (see Fig. 3) has been fully processed, i.e. the first pass of C1 decoding is completed. Thereafter, the RS decoder 5 which, at this time is in C2 level, is positioned for reading a C2 code word (28 bytes) at the i-position 0 (460 in Fig. 4). C2 code words are read along diagonals of B1 and B2 memory blocks. Addressing of C2 code words (C2-CDW) in read operations is in accordance with the following algorithm:

```
for(cycle=0; cycle<=108; ++cycle)
  {for(j=0; j<28; ++j)
    {i=cycle+4*j;                                    (1)
     C2_CDW[j]=memory[i][j];
     }
  }
```

where memory [i][j] is a location in system memory 2.

In each C2 decoder cycle the RS decoder 5 is trying to correct up to 4 erasures or 2 errors or any combinations of errors and erasures on the basis of the following condition: $2*t+E<d$, where t is the number of errors in a code word, E is the number of erasures, d is the Hamming distance of RS code.

Erasure information (C1 pointer information) assigned during C1 decoding cycles is used by C2 decoding and correction operations. In step 460 uncorrectable C2 code words are not marked, i.e. erasure flags are not assigned.

In total the RS decoder 5 (at C2 level) continuously performs 109 C2 decoding and correcting cycles (step 460 in Fig.4). After those operations 109 C2 code words are processed and the first pass of C2 decoding is completed. After 109 C2 decoding and correcting cycles the content of the counter Count_ps (counter of passes; 470 in Fig. 4) is increased and becomes 2.

During step 440 again the condition Count_ps=2-? is analysed. If the result is YES a step 480 has to be performed and the erasure flags of all data bytes in the B1 memory block are cleared. Then, the RS decoder 5 (at C1 level) again is positioned for reading C1 code words at i-position 109 during step 490. In each succeeding C1 decoder cycle the RS decoder 5 is positioned forward, and the C1 code word at the next successively higher i-position is read. Thus, during the second C1 decoder cycle the RS decoder 5 is positioned at i-position 110. In the same manner the addressing is continued until i-position 217. During each C1 decoder ycle the RS decoder 5 is trying to correct up to two errors. If three or more errors occur, which of course are not corrected, erasure flags are assigned to all uncorrected bytes of the C1 code word.

In general, the RS decoder 5 (at C1 level) continuously performs again 109 decoding and correcting cycles (step 490 in Fig. 4). Then B1 memory block has been fully processed, i.e. the second pass of C1 decoding is completed. Following, the RS decoder 5 (at C2 level) is again positioned to read the C2 code word (28 bytes) at i-position 0. C2 code words are read along diagonals of B2 and B1 memory blocks, step 500. Addressing of C2 code words in reading operations is performed according to the above-mentioned algorithm (1).

The RS decoder 5 again is trying to correct up to 4 erasures or 2 errors or any combinations of errors and erasures by each C2 decoder cycle. If the RS decoder 5 is not able to correct the current C2 code word data bytes are flagged. Thereafter, the processed C2 code words are written into output buffer 7 (see Fig. 2).

The RS decoder (at C2 level) continuously performs 109 C2 decoding and correcting cycles. After 109 C2 code words have been processed, a second pass of C2 decoding is completed. Then, the B1 memory block with erasure information is moved into the B2 memory block of system memory 2 (see step 510 in Fig. 4). A signal DONE is generated in the timing and control element 4. This signal gives the information that all data bytes in the system memory 2 have been processed exactly twice. Then step 410 is executed again.

*3. Burst error correction*

In the following the burst error correction utilising the method according to the invention is explained.

*A) Correction of a C1 code word burst with high input error rate (C1 code words are fully or almost fully destroyed)*

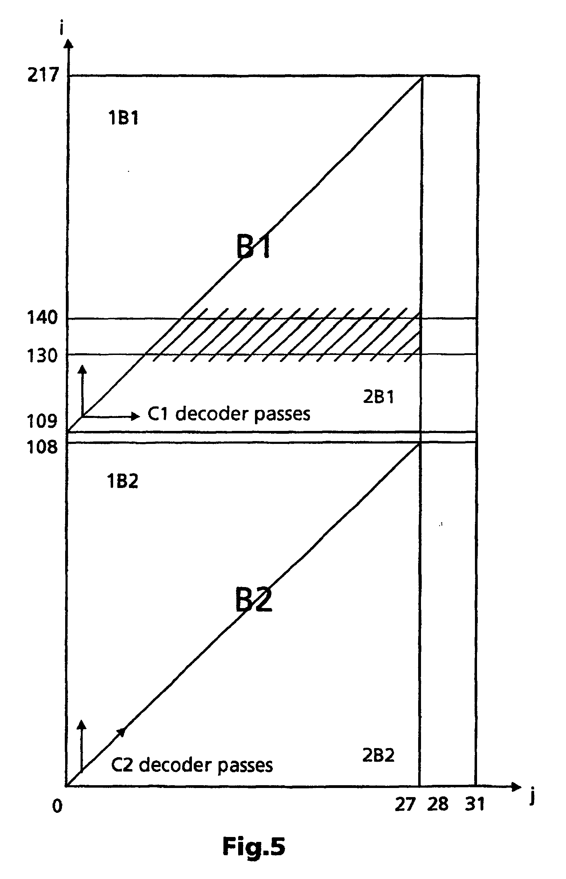

Detailed operations of the correction method of the CIRC correction code in accordance with the invention are described in connection with the burst error. It is assumed that the B2 memory block has already been corrected (in a previous stage) and in the B2 memory block there are no errors. The B1 memory block is loaded from (by) input logic 1. At i-positions 130,...,140 there is a burst error (11 corrupted C1 code words, see Fig. 5).

RS decoder 5 (at C1 level) starts and tries to decode and correct successively 109 C1 code words in the B1 memory block. Code words at i-positions 130,...,140 are uncorrectable and therefore are flagged (for each byte in each C1 code word the erasure flag is assigned).

Then, the RS decoder 5 (at C2 level) starts and tries to decode and correct successively 109 C2 code words in B1 and B2 memory blocks. During that operation the RS decoder 5 (at C2 level) has to read bytes from memory sectors 2B1 and 1B2 (see Fig. 5). After completion of the first pass of the RS decoder 5 (109 C1 passes and 109 C2 passes) flagged bytes at i-positions (130-140) within memory sector 2B1 are corrected, while flagged bytes at i-positions (130-140) within memory sector 1B1 remain uncorrected.

In a second pass the RS decoder 5 (at C1 level) tries to decode and correct successively 109 C1 code words in the B1 memory block. Code words at positions 130,...,140 are again flagged, but in fact, at this time errors are only present in memory sector 1B1. Then, the RS decoder 5 (at C2 level) starts and tries to decode and correct successively 109 C2 code words in B1 and B2 memory blocks.

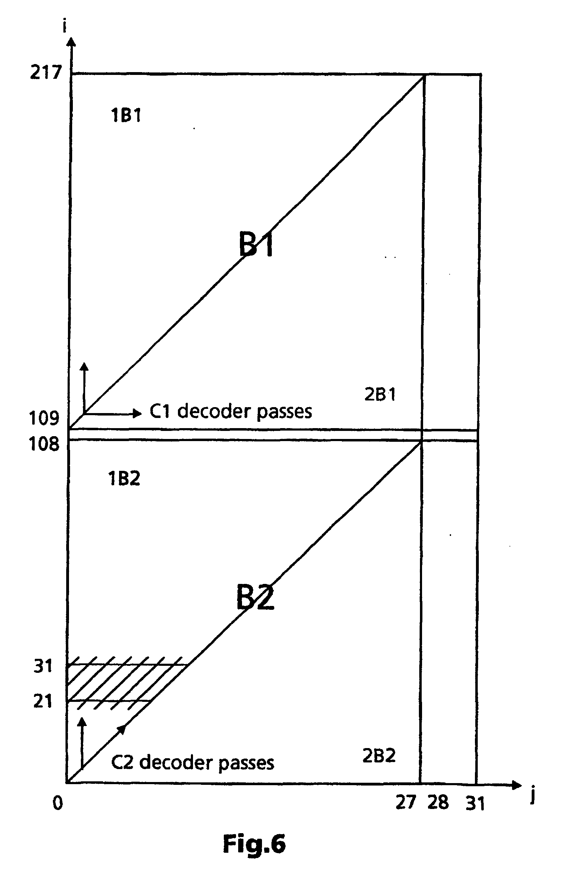

In a next stage the corrected B1 memory block with erasure information is coped into the B2 memory block of the system memory (see Fig. 6). Thereafter, a new data block is loaded from input logic 1 into the B1 memory block and the CIRC decoder starts again. Now remaining errors are (exist) in the memory sector 1B2 (bytes with erasure information). The RS decoder 5 (at C1 level) starts and tries to decode and correct successively 109 C1 code words in the B1 memory block.

Then, the RS decoder 5 (at C2 level) starts and tries to decode and correct successively 109 C2 code words in B1 and B2 memory blocks. During this stage errors in memory sector 1B2 (remaining errors at i-positions 21,...,31) are corrected.

The CIRC decoder implementing the method according to the invention is able to correct 14 corrupted C1 code words (limit) with a high input error rate.

*B) Correction of a C1 code word burst with low input error rate (each C1 code word with 3 to 6 errors)*

The CIRC decoder implementing the method according to the invention is working very efficiently if corrupted C1 code words have a low input error rate. This will be explained in the following.

In C2 code word error-correction (first pass of CIRC decoder) the RS decoder 5 (at C2 level) is able to correct any random combination of erasures (up to 4 erasures), i.e. during second pass CIRC decoder the RS decoder 5 (at C1 level) is able to correct any C1 code words which have not been corrected during the first pass of the CIRC decoder (at C1 level). Therefore, during the second pass of the CIRC decoder it is possible to correct any C2 code words which have not been corrected during the first pass of the CIRC decoder (at C2 level).

This can be shown by referring to Fig. 7. In Fig. 7 results of the error-correction for (of) two CIRC decoders are depicted - a conventional CIRC decoder and a CIRC decoder implementing the method according to the invention, respectively. Results of a conventional CIRC decoder are depicted by means of <u>dashed</u> lines. Results of a CIRC decoder implementing the method according to the invention are depicted by means of <u>solid</u> lines.

Results are shown for the following combinations of errors:

1. Bust error of 20 C1 code words with 3 errors in each C1 code word (random errors).
2. Burst error of 20 C1 code words with 4 errors in each C1 code word.
3. Burst error of 20 C1 code words with 5 errors in each C1 code word.
4. Burst error of 20 C1 code words with 6 errors in each C1 code word.
5. Burst error of 30 C1 code words with 3 errors in each C1 code word.
6. Burst error of 30 C1 code words with 4 errors in each C1 code word.
7. Burst error of 30 C1 code words with 5 errors in each C1 code word.
8. Burst error of 30 C1 code words with 6 errors in each C1 code word.
9. Burst error of 40 C1 code words with 3 errors in each C1 code word.
10. Burst error of 40 C1 code words with 4 errors in each C1 code word.
11. Burst error of 40 C1 code words with 5 errors in each C1 code word.
12. Burst error of 40 C1 code words with 6 errors in each C1 code word.

Results of burst-error correction of 20 C1 code words with different numbers of errors in each C1 code word are depicted in Fig. 7 (circles). The CIRC decoder implementing the method according to the invention is able to correct a burst error of 20 C1 code words with 3 and 4 errors in each code word. If 5 and 6 errors occur in C1 code words the CIRC decoder implementing the method according to the invention is not able to correct a burst error of 20 C1 code words. However, the output erasure rate of audio data CIRC decoder implementing the method according to the invention is significantly lower.

For the CIRC decoder implementing the method according to the invention a better performance in error-correction is obtained for the correction of bust errors of 30 C1 code words compared to a conventional CIRC decoder. The CIRC decoder implementing the method according to the invention is able to correct a burst error of 30 C1 code words with 3 errors in each code word. The output erasure rate of audio data in the CIRC decoder implementing the method according to the invention is also lower (results are depicted by means of square points). Advantages of the CIRC decoder implementing the method according to the invention decrease with further growing input error rate.

Limitation for both, the conventional CIRC decoder and the CIRC decoder implementing the method according to the invention are burst error 14 C1 (completely corrupted) code words. In this case the error correction performance for a conventional CIRC decoder and for a CIRC decoder implementing the method according to the invention does not differ.

**Claims**

1. Error-correction method for use in a process of decoding cross-interleaved Reed-Solomon code CIRC that corrects errors in a block of 109 C1 code words each consisting of 32 data bytes, and a block of 109 C2 code words each consisting of 28 data bytes, said block of C1 code words being positioned in a memory comprising a memory block with memory locations $N_{ij}$ for the data bytes with i=0, ..., 217; j=0, ..., 31 at the positions i=109, ... ,217 and j=0, ..., 31; said block of C2 code words being located along diagonals of said memory, said diagonals starting at the positions i=0, ..., 108 and j=0 and ending at the positions i=108, ..., 216 and j=27; a previous block of C1 code words being positioned in the memory at the positions i=0, ... ,108 and j=0, ..., 31; the method comprising the following steps:

   a1) reading and decoding (450) said C1-code words in the current block from said locations $N_{ij}$ utilising decoder means (5) starting by i=109 and j=0;
   a2) correcting said C1-code words at least partially;
   b1) reading and decoding (460) said C2-code words from said locations $N_{ij}$ utilising said decoder means (5) along said diagonals of said memory starting by position i=0 and j=0; and
   b2) correcting said C2-code words at least partially;
   c) repeating steps a1, a2 and b1, b2.

2. Method according to claim 1, wherein correcting of said C1-cod words and said C2-code words is performed by means of an erasure correction method of Reed-Solomon code.

3. Method according to claim 2, including the step of providing first erasure information by assigning first erasure flags to data bytes of said C1-code words which are erroneous and not corrected during step a2).

4. Method according to claim 3, including the step of using said first erasure information for error correction in said step b2).

5. Method according to claim 3 or 4, including the step of providing second erasure information by assigning second erasure flags to data bytes of said C1-code words which are erroneous and not corrected in said repeating of step a2).

6. Method according to claim 5, including the step of using said second erasure information for error correction in said step of repeating step b2).

7. Method according to claim 5 or 6, including the step of providing third erasure information by assigning third erasure flags to data bytes of said C2-code words which are erroneous and not corrected in said repeating of step b2).

8. Method according to one of the claims 1 to 7, wherein the steps of correcting said read C1-code words and correcting said read C2-code words, respectively, are performed on the basis of

$$2*t+E<d$$

   where t is the number of errors, E is the number of erasures and d is Hamming distance.

9. Method according to claim 8 wherein d is 5.

10. Method according to one of the preceding claims, wherein said several locations $N_{ij}$ form a memory block B2 with B2-locations $N^1_{ij}$ (i=0, ..., 108; j=0, ..., 31) and a memory block B1 with B1-location $N^2_{ij}$ (i=109, ..., 217; j=0, ..., 31), each of said B1-locations $N^1_{ij}$ and B2-locations $N^2_{ij}$ containing one of said data bytes, the method including the step of moving data bytes contained in said memory block B1 into said memory block B2.

11. Apparatus for detection and correction of errors in a process of decoding cross-interleaved Reed-Solomon code CIRC that corrects errors in a stream of data, the apparatus comprising:

   - memory means (2) comprising a memory block with memory locations $N_{ij}$ with i=0, ..., 217; j=0, ..., 31, for storing said stream of data as 109 C1-code words, each consisting of 32 data bytes, in the memory locations at the positions i=109, ... ,217 and j=0, ..., 31; each of said memory locations $N_{ij}$ containing a data byte of said stream of data; and for storing said stream of data as 109 C2-code words, each consisting of 28 data bytes along diagonals of said memory means (2), said diagonals starting at the positions i=0, ..., 108 and j=0 and ending at the positions i=108, ..., 216 and j=27;
   - means for reading said C1-code words in a first pass starting by i=109 and j=0;
   - means for decoding said read C1-code words of the first pass;
   - means for correcting said decoded C1-code words of the first pass;
   - means for reading said C2-code words in a first pass starting at the position i=0 and j=0;
   - means for decoding said read C2-code words of the first pass; and
   - means for correcting said decoded C2-code words of the first pass;
   - means for reading said C1-code words in a second pass starting by i=109 and j=0;
   - means for decoding said read C1-code word of the second pass;
   - means for correcting said decoded C1-code words of the second pass;
   - means for reading said C2-code words in a second pass starting at the position i=0 and j=0
   - means for decoding said read C2-code words of the second pass; and
   - means for correcting said decoded C2-code words of the second pass.

12. Apparatus according to claim 11, wherein said means for decoding said read C1-cod words and said means for decoding said read C2-code words are provided in a decoder suitable for decoding cross-interleaved Reed-Solomon code CIRC.

**Patentansprüche**

1. Fehlerkorrektur-Verfahren für die Verwendung in einem Prozess zum Dekodieren eines cross-interleaved Reed-Solomon-Codes CIRC, bei dem Fehler in einem Block aus 109 C1-Code-Worten, von denen jedes aus 32 Daten-Bytes besteht, und in einem Block aus 109 C2-Code-Worten, von denen jedes aus 28 Daten-Bytes besteht, korrigiert werden, wobei der Block aus C1-Code-Worten in einem Speicher positioniert ist, der einen Speicherblock mit Speicherplätzen $N_{ij}$ für die Daten-Bytes mit i=0,..., 217; j=0,..., 31 an den Plätzen i=109,..., 217, und j=0,..., 31 umfasst; wobei der Block aus C2-Code-Worten entlang von Diagonalen des Speichers lokalisiert ist, wobei die Diagonalen an den Positionen i=0,..., 108 und j=0 beginnen und an den Positionen i=108,..., 216 und j=27 enden; wobei ein vorhergehender Block aus C1-Code-Worten in dem Speicher an den Positionen i=0,..., 108 und j=0,..., 31 positioniert ist; wobei das Verfahren die folgenden Schritte umfasst:

   a1) Lesen und Dekodieren (450) der C1-Code-Worte in dem gegenwärtigen Block aus den Plätzen $N_{ij}$ unter Verwendung von Dekodiermitteln, beginnend mit i=109 und j=0;
   a2) Korrigieren der C1-Code-Worte wenigstens teilweise;
   b1) Lesen und Dekodieren (460) der C2-Code-Worte aus den Plätzen $N_{ij}$ unter Verwendung der Dekodierermittel (5) entlang den Diagonalen des Speichers, beginnend mit der Position i=0 und j=0; und
   b2) Korrigieren der C2-Code-Worte wenigstens teilweise;
   c) Wiederholen der Schritte a1, a2 und b1, b2.

2. Verfahren nach Anspruch 1, bei dem das Korrigieren der C1-Code-Worte und der C2-Code-Worte mittels eines Lösch-Korrektur-Verfahrens des Reed-Solomon-Codes ausgeführt wird.

3. Verfahren nach Anspruch 2, das den Schritt einschließt, erste Lösch-Informationen durch Zuordnen von ersten Lösch-Flags zu Daten-Bytes der C1-Code-Worte vorzusehen, die fehlerhaft sind und nicht beim Schritt a2) korrigiert wurden.

4. Verfahren nach Anspruch 3, das den Schritt einschließt, die ersten Lösch-Informationen zur Fehlerkorrektur im Schritt b2) zu verwenden.

**5.** Verfahren nach Anspruch 3 oder 4, das den Schritt einschließt, zweite Lösch-Informationen durch Zuordnen von zweiten Lösch-Flags zu Daten-Bytes der C1-Code-Worte vorzusehen, die fehlerhaft sind und nicht beim Wiederholen des Schrittes a2) korrigiert wurden.

**6.** Verfahren nach Anspruch 5, das den Schritt einschließt, die zweiten Lösch-Informationen zur Fehlerkorrektur in dem Schritt zur Wiederholung des Schrittes b2) zu verwenden.

**7.** Verfahren nach Anspruch 5 oder 6, das den Schritt einschließt, dritte Lösch-Informationen durch Zuordnen dritter Lösch-Flags zu Daten-Bytes der C2-Code-Worte vorzusehen, die fehlerhaft sind und nicht bei der Wiederholung des Schrittes b2) korrigiert wurden.

**8.** Verfahren nach einem der Ansprüche 1 bis 7, bei dem die Schritte zur Korrektur der gelesenen C1-Code-Worte bzw. zur Korrektur der gelesenen C2-Code-Worte auf der Basis von

$$2*t+E<d$$

ausgeführt werden, wobei t die Zahl der Fehler, E die Zahl von Löschungen und d der Hamming-Abstand ist.

**9.** Verfahren nach Anspruch 8, bei dem d=5 ist.

**10.** Verfahren nach einem der vorhergehenden Ansprüche, bei dem die mehreren Plätze $N_{ij}$ einen Speicherblock B2 mit B2-Plätzen $N^1_{ij}$ (i=0,..., 108; j=0,..., 31) und einen Speicherblock B1 mit B1-Plätzen $N^2_{ij}$ (i=109,..., 217; j=0,..., 31) bilden, wobei jeder der B1-Plätze $N^1_{ij}$ und B2-Plätze $N^2_{ij}$ eines der Daten-Bytes enthalten, wobei das Verfahren den Schritt einschließt, in dem Speicherblock B1 enthaltene Daten in den Speicherblock B2 zu bewegen.

**11.** Vorrichtung zur Feststellung und Korrektur von Fehlern in einem Prozess zum Dekodieren eines cross-interleaved Reed-Solomon-Codes CIRC, die Fehler in einem Datenstrom korrigiert, wobei die Vorrichtung umfasst:

- Speichermittel (2), die einen Speicherblock mit Speicherplätzen $N_{ij}$ mit i=0,..., 217; J=0,..., 31 umfassen, um den Datenstrom als 109 C1-Code-Worte, von denen jedes aus 32 Daten-Bytes besteht, in den Speicherplätzen an den Positionen i=109,..., 217 und j=0,..., 31 zu speichern; wobei jeder der Speicherplätze $N_{ij}$ ein Daten-Byte des Datenstroms enthält, und um den Datenstrom als 109 C2-Code-Worte, von denen jedes aus 28 Daten-Bytes besteht, entlang von Diagonalen der Speichermittel (2) zu speichern, wobei die Diagonalen an den Positionen i=0,..., 108 und j=0 beginnen und an den Positionen i=108,..., 216 und j=27 enden;
- Mittel zum Lesen der C1-Code-Worte in einem ersten Durchlauf, der bei i=109 und j=0 beginnt;
- Mittel zum Dekodieren der gelesenen C1-Code-Worte des ersten Durchlaufs;
- Mittel zum Korrigieren der dekodierten C1-Code-Worte des ersten Durchlaufs;
- Mittel zum Lesen der C2-Code-Worte in einem ersten Durchlauf, der an der Position i=0 und j=0 beginnt;
- Mittel zum Dekodieren der gelesenen C2-Code-Worte des ersten Durchlaufs; und
- Mittel zum Korrigieren der kodierten C2-Code-Worte des ersten Durchlaufs;
- Mittel zum Lesen der C1-Code-Worte in einem zweiten Durchlauf, der bei i=109 und j=0 beginnt;
- Mittel zum Dekodieren der gelesenen C1-Code-Worte des zweiten Durchlaufs;
- Mittel zum Korrigieren der dekodierten 01-Code-Worte des zweiten Durchlaufs;
- Mittel zum Lesen der C2-Code-Worte in einem zweiten Durchlauf, der an der Position i=0 jnd j=0 beginnt;
- Mittel zum Dekodieren der gelesenen C2-Code-Worte des zweiten Durchlaufs; und
- Mittel zum Korrigieren der dekodierten C2-Code-Worte des zweiten Durchlaufs.

**12.** Vorrichtung nach Anspruch 11, bei der die Mittel zum Dekodieren der gelesenen C1-Code-Worte und die Mittel zum Dekodieren der gelesenen C2-Code-Worte in einem Dekodierer vorgesehen sind, der zum Dekodieren von cross-interleaved Reed-Solomon-Code-CIRC geeignet ist.

**Revendications**

**1.** Méthode de correction d'erreurs destinée à être utilisée dans un processus de décodage d'un code de type cross interleave Reed-Solomon (CIRC) corrigeant des erreurs dans un bloc de 109 mots de code C1 comprenant chacun 32 octets de données et dans un bloc de 109 mots de code C2 comprenant chacun 28 octets de données, ledit bloc de mots de code C1 étant positionné dans une mémoire comprenant un bloc mémoire avec les emplacements mémoire $N_{ij}$ pour les octets de données avec i=0, ..., 217 ; j=0, ..., 31 aux positions i=109, ..., 217 et j=0, ..., 31 ; ledit bloc de mots de code C2 étant localisé le long des diagonales de ladite mémoire, lesdites diagonales commençant aux positions i=0, ..., 108 et j=0 et se terminant aux positions i=108, ..., 216 et j=27, un précédent bloc de mots de code C1 étant positionné dans la mémoire aux positions i=0, ..., 108 et j=0, ..., 31 ; la méthode comprenant les étapes suivantes :

a1) lecture et décodage (450) desdits mots de code C1 dans le bloc actuel à partir des emplacements $N_{ij}$ utilisant les moyens de décodeur (5) à partir de i=109 etj=0 ;
a2) correction desdits mots de code C1 au moins partiellement ;
b1) lecture et décodage (460) desdits mots de code C2 à partir desdits emplacements $N_{ij}$ utilisant lesdits moyens de décodeur (5) le long desdites diagonales de ladite mémoire à partir de la position i=0 et j=0 ; et
b2) correction desdits mots de code C2 au moins partiellement ;
c) répétition des étapes a1, a2 et b1, b2.

2. Méthode selon la revendication 1, dans laquelle la correction desdits mots de code C1 et desdits mots de code C2 est effectuée à l'aide d'une méthode de correction/effacement de code de Reed-Solomon.

3. Méthode selon la revendication 2, incluant l'étape de mise à disposition des premières informations d'effacement en affectant les premiers drapeaux d'effacement aux octets de données desdits mots de code C1 erronés et n'ayant pas été corrigés au cours de l'étape a2).

4. Méthode selon la revendication 3, incluant l'étape d'utilisation desdites premières informations d'effacement pour la correction des erreurs dans ladite étape b2).

5. Méthode selon la revendication 3 ou 4, incluant l'étape de mise à disposition des deuxièmes informations d'effacement en affectant les deuxièmes drapeaux d'effacement aux octets de données desdits mots de code C1 erronés et n'ayant pas été corrigés lors de ladite répétition de l'étape a2).

6. Méthode selon la revendication 5, incluant l'étape d'utilisation desdites deuxièmes informations d'effacement pour la correction des erreurs lors de ladite étape de répétition de l'étape b2).

7. Méthode selon la revendication 5 ou 6, incluant l'étape de mise à disposition des troisièmes informations d'effacement en affectant les troisièmes drapeaux d'effacement aux octets de données desdits mots de code C2 erronés et n'ayant pas été corrigés lors de ladite répétition de l'étape b2).

8. Méthode selon l'une des revendications 1 à 7, dans laquelle les étapes de correction desdits mots de code C1 lus et de correction desdits mots de code C2 lus, respectivement, sont effectuées sur la base :

$$2*t+E<d$$

où t correspond au nombre d'erreurs, E correspond au nombre d'effacements et d correspond à la distance Hamming.

9. Méthode selon la revendication 8 dans laquelle d équivaut à 5.

10. Méthode selon l'une des précédentes revendications, dans laquelle plusieurs emplacements $N_{ij}$ forment un bloc mémoire B2 avec des emplacements B2 $N1_{ij}$ (i=0, ..., 108 ; j=0, ..., 31) et un bloc mémoire B1 avec des emplacements B1 $N2_{ij}$ (i=109, ..., 217 ; j=0, ..., 31), chacun desdits emplacements B1 $N1_{ij}$ et B2 $N2_{ij}$ comprenant l'un desdits octets de données, la méthode incluant l'étape de déplacement des octets de données stockés présents dans ledit bloc mémoire B1 vers ledit bloc mémoire B2.

11. Appareil détecteur et correcteur d'erreurs dans un processus de décodage d'un code de type cross interleave Reed-Solomon CIRC qui corrige les erreurs présentes dans un flux de données, comprenant

- dés moyens de mémoire (2) incluant un bloc mémoire avec des emplacements mémoire $N_{ij}$ avec i=0, ..., 217 ; j=0, ..., 31, pour stocker ledit flux de données en tant que 109 mots de code C1, chacun comprenant 32 octets de données, dans les emplacements mémoire aux positions i=109, ..., 217 et j=0, ..., 31 ; chacun desdits emplacements mémoire $N_{ij}$ comprenant un octet de données dudit flux de données ; et pour stocker ledit flux de données en tant que 109 mots de code C2, chacun comprenant 28 octets de données le long des diagonales desdits moyens de mémoire (2), lesdites diagonales commençant aux positions i=0, ..., 108 et j=0 et se terminant aux positions i=108, ..., 216 et j=27 ;
- des moyens de lecture desdits mots de code C1 lors d'une première passe à partir de la position i=109 et j=0 ;
- des moyens de décodage desdits mots de code C1 de la première passe ;
- des moyens de correction desdits mots de code C1 décodés de la première passe ;
- des moyens de lecture desdits mots de code C2 lors d'une première passe à partir de la position i=0 et j=0 ;
- des moyens de décodage desdits mots de code C2 lus de la première passe ; et
- des moyens de correction desdits mots de code C2 décodés de la première passe ;
- des moyens de lecture desdits mots de code C1 lors d'une deuxième passe à partir de la position i=109 et j=0 ;
- des moyens de décodage desdits mots de code C1 lus de la deuxième passe ;
- des moyens de correction desdits mots de code C1 décodés de la deuxième passe ;
- des moyens de lecture desdits mots de code C2 lors d'une deuxième passe à partir de la position i=0 et j=0 ;
- des moyens de décodage desdits mots de code C2 lus de la deuxième passe ; et
- des moyens de correction desdits mots de code C2 décodés de la deuxième passe.

12. Appareil selon la revendication 11, dans lequel lesdits moyens de décodage desdits mots de code C1 lus et lesdits moyens de décodage desdits mots de code C2 lus sont fournis par un décodeur prenant en charge le décodage avec un code de type cross interleave Reed-Solomon CIRC.

0   256   240

C1 code words

C2 code words

**Fig.1
(prior art)**

Fig.2

Fig.3

START

data block is ready in input logic-? ～410

NO

YES

write a data block from input logic into B1 of RAM ～420

Count_ps=1 ～430

Count_ps=2-? ～440

YES

clear a erasure flags by data bytes in B1 block of RAM ～480

NO

C1 decoder passages, to correct B1 block (109 C1 code words) ～450

C2 decoder passages, to correct 1/2 B1 block and 1/2 B2 block (109 C2 code words) ～460

Count_ps= Count_ps+1 ～470

C1 decoder passages, to correct B1 block (109 C1 code words) ～490

C2 decoder passages, to correct 1/2 B1 block and 1/2 B2 block (109 C2 code words) write the corrected C2 code word into output buffer by each decoding cycle of C2 decoder ～500

copy B1 block into B2 block of RAM, generate the signal-DONE ～510

**Fig.4**

**Fig.5**

**Fig.6**

**Fig.7**